# EUROPÄISCHE PATENTANMELDUNG

(11) **EP 0 735 372 A1**
(43) Veröffentlichungstag der Anmeldung: **02.10.1996**
(21) Anmeldenummer: 96103249.7
(22) Anmeldetag: 02.03.1996
(51) Int. Cl.: G01R 1/073, H01R 23/72

(54) **Prüfadapter**

(30) Priorität: 29.03.1995 DE 19511565
(71) Anmelder: atg test systems GmbH, D-97877 Wertheim (DE)
(72) Erfinder: Prokopp, Manfred, 97877 Wertheim (DE); Baumann, Arnold, 97941 Tauberbischofsheim (DE)
(74) Vertreter: Gleiss & Grosse

(57) **Zusammenfassung**

Die Erfindung betrifft einen Prüfadapter zum elektrischen Kontaktieren eines Prüflings mit einem rasterartig aufgebauten Kontaktpunktfeld einer Prüfeinrichtung, wobei der Prüfadapter eine Umsetzeinrichtung aufweist, die als Leiterplatte ausgebildet ist und auf ihrer dem Kontaktpunktfeld zuordenbaren Seite eine prüffeldspezifische Kontaktanordnung und auf ihrer dem Prüfling zuordenbaren Seite eine prüflingsspezifische Kontaktanordnung aufweist, wobei einander zugeordnete Kontakte der beiden Kontaktanordnungen leitend miteinander verbunden sind, und mit einer Vielzahl federnd nachgiebiger Kontaktelementen, die mit der prüflingsspezifischen Kontaktanordnung leitend in Verbindung stehen und dem Kontaktieren des Prüflings dienen.

Es ist vorgesehen, daß den Kontaktelementen (48) Bohrungen (36) einer Aufnahmeplatte (34) zugeordnet sind, daß in den Bohrungen (36) den Kontaktelementen (48) zugeordnete Federn (38) lagern und daß die Leiterplatte (14) und die Aufnahmeplatte (34) derart einander gegenüberliegen, insbesondere derart aufeinanderliegen, daß die Federn (38) die Kontakte (22) der prüflingsspezifischen Kontaktanordnung kontaktieren.

## Beschreibung

Die Erfindung betrifft einen Prüfadapter zum elektrischen Kontaktieren eines Prüflings mit einem rasterartig aufgebauten Kontaktpunktfeld einer Prüfeinrichtung nach dem Oberbegriff des Anspruchs 1.

Derartige Prüfadapter sind bekannt. So zeigt beispielsweise die US-PS 3,806,801 einen Prüfadapter, der eine Umsetzeinrichtung aufweist, die als Leiterplatte ausgebildet ist und auf ihrer einem Kontaktpunktfeld der Prüfeinrichtung zuordenbaren Seite eine prüffeldspezifische Kontaktierung aufweist. Auf der dem Prüfling zuordenbaren Seite weist die Umsetzeinrichtung eine prüflingsspezifische Kontaktanordnung auf, wobei die einander zugeordneten Kontakte der beiden Kontaktanordnungen leitend miteinander verbunden sind. Der Prüfadapter weist ferner eine Tastsonde auf, die eine Vielzahl parallel zueinander angeordneter Kontaktnadeln besitzt, die als sogenannte Knickdrähte ausgebildet sind. Die Kontaktnadeln sind hierbei zwischen Ausrichteplatten gehalten, die beabstandet zueinander angeordnet sind, so daß die Kontaktnadeln bei Beaufschlagung mit einem Kontaktdruck durchbiegen können. Hierbei ist nachteilig, daß der gesamte Aufbau der Tastsonde kompliziert und damit nur aufwendig herstellbar ist. So müssen beispielsweise die einzelnen Kontaktnadeln, um Kurzschlüsse zwischen diesen zu vermeiden, mit einem Isoliermaterial versehen werden. Darüber hinaus setzt sich die gesamte Anordnung aus relativ vielen, miteinander zu verbindenden Teilen zusammen, wobei aufgrund der Lange der Kontaktnadeln eine große Bauhöhe vorliegt. Da in der Regel die Prüfadapter nur zum Prüfen einer Serie eines bestimmten Prüflings verwendet werden können und zur Prüfung weiterer Prüflinge neue beziehungsweise entsprechend umgebaute Prüfadapter notwendig sind, ist hiermit ein relativ hoher Aufwand verbunden. Letzteres gilt insbesondere für das die Kontaktnadeln aufnehmende Bauteil.

Der Erfindung liegt daher die Aufgabe zugrunde, einen Prüfadapter der gattungsgemäßen Art zu schaffen, der einfach aufgebaut ist und leicht unterschiedlichen Anforderungen anpaßbar ist.

Erfindungsgemäß wird diese Aufgabe durch die im Anspruch 1 genannten Merkmale gelöst. Dadurch, daß den Kontaktelementen Bohrungen einer Aufnahmeplatte zugeordnet sind, daß in den Bohrungen den Kontaktelementen zugeordnete Federn lagern und daß die Leiterplatte und die Aufnahmeplatte derart einander gegenüberliegen, insbesondere derart aufeinanderliegen, daß die Federn die Kontakte der prüflingsspezifischen Kontaktanordnung kontaktieren, ist der gesamte Aufbau des Prüfadapters sehr einfach und kompakt, insbesondere mit kleiner Bauhöhe, gehalten und auf die Anordnung einer Vielzahl einzelner Teile kann verzichtet werden. Insbesondere dadurch, daß die Federn der Kontaktelemente direkt in den Bohrungen lagern beziehungsweise geführt sind, das heißt, keine weiteren Führungshülsen oder ähnliches vorgesehen sind, kann eine einmal mit den Bohrungen versehene Aufnabmeplatte unmittelbar zur Anordnung der Kontaktelemente verwendet werden. Die in der Aufnahmeplatte eingebrachten Bohrungen sind in einem Raster angeordnet, das der prüflingsspezifischen Kontaktanordnung entspricht. Hierbei kann sehr vorteilhaft eine für die Herstellung des Prüflings verwendete Vorgabe, beispielsweise ein Löt- und/oder Kontaktierungs- und/oder Bohrungsschema für die Kontaktierung des Prüflings, als Bohrschema zum Einbringen der Bohrungen in die Aufnahmeplatte verwendet werden. Hierdurch wird sehr vorteilhaft erreicht, daß das Bohrraster der Aufnahmeplatte exakt der prüflingsspezifischen Kontaktanordnung entspricht, so daß ein zielgenaues und sicheres Kontaktieren des Prüflings möglich ist.

Insbesondere ist vorteilhaft, daß durch den Wegfall irgendwelcher zusätzlicher Führungselemente für die Federn der Kontaktelemente der Durchmesser der Bohrungen ausschließlich auf den Durchmesser der Federn beschränkt werden kann. Hierdurch wird es möglich, die Kontaktelemente in einem extrem geringen Abstand zueinander anzuordnen. Es kann daher ein sehr enges Rastermaß realisiert werden.

In vorteilhafter Ausgestaltung der Erfindung ist vorgesehen, daß der Aufnahmeplatte eine Führungsplatte zugeordnet ist, die mit den Bohrungen der Aufnahmeplatte fluchtende Führungsbohrungen für die Kontaktelemente aufweist. Diese Führungsbohrungen der Führungsplatte übernehmen hierbei vorteilhafterweise eine besonders exakte Ausrichtung und Führung der Kontaktelemente, so daß diese speziell bei sehr fein vorgegebenen Rastern der Kontaktanordnung des Prüflings den jeweils zugeordneten Kontakt treffen. Durch eine Wahl der Stärke der Führungsplatte kann die Führungslänge der Kontaktelemente variiert werden, so daß je nach Länge der eingesetzten Kontaktelemente eine optimale Führungswirkung erzielbar ist. Die Führungsbohrungen lassen sich ebenfalls mit dem bereits vorliegenden Bohrprogramm einbringen.

In weiterer vorteilhafter Ausgestaltung der Erfindung ist vorgesehen, daß die Führungsplatte und die Aufnahmeplatte lösbar miteinander verbunden sind Hierdurch wird es möglich, durch Abnehmen der Führungsplatte von der Aufnahmeplatte die Kontaktelemente und/oder die den Kontaktelementen zugeordneten Federn auszutauschen. Einerseits wird hiermit erreicht, daß Kontaktelement und Feder zwei getrennte Teile sein können, die jeweils auf die unterschiedlichen an sie gestellten Anforderungen anpaßbar sind. Beispielsweise können die Federn gegen andere Federn mit einer anderen Kennlinie ausgetauscht werden, ohne daß es eines Austausches der Kontaktelemente bedarf. Demgegenüber können ebenfalls die Kontaktelemente ausgetauscht werden, so daß beispielsweise mit der gleichen Anordnung Kontaktelemente mit einer unterschiedlichen Länge und/oder einer unterschiedlichen Gestaltung ihres Kontaktkopfes einsetzbar sind.

Weitere vorteilhafte Ausgestaltungen der Erfindung ergeben sich aus den übrigen in den Unteransprüchen genannten Merkmalen.

Die Erfindung wird nachfolgend in Ausführungsbeispielen anhand der zugehörigen Zeichnungen näher erläutert. Es zeigen:
- Figur 1: eine schematische Schnittdarstellung eines Prüfadapters und
- Figur 2: eine schematische Schnittdarstellung eines Prüfadapters in einer weiteren Ausführungsvariante.

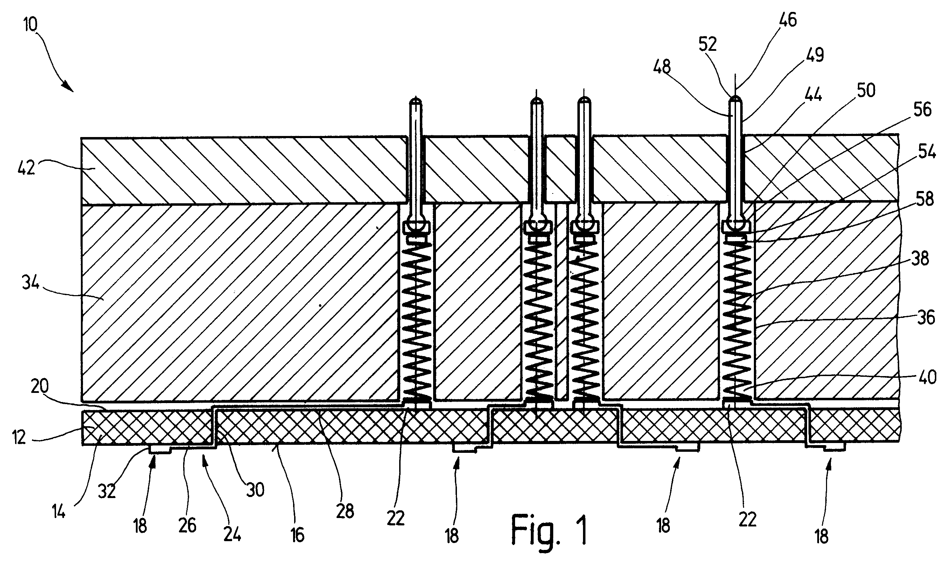

Die Figur 1 zeigt einen allgemein mit 10 bezeichneten Prüfadapter. Der Prüfadapter 10 weist eine Umsetzeinrichtung 12 auf. Die Umsetzeinrichtung 12 wird von einer Leiterplatte 14 gebildet, die an ihrer, einem nicht dargestellten Kontaktpunktfeld einer Prüfeinrichtung zugewandten Seite 16 eine Kontaktierung 18 aufweist. Die Kontaktierung 18 ist hierbei durch eine prüffeldspezifische Kontaktanordnung vorgegeben. An ihrer der Prüfeinrichtung abgewandten Seite 20 besitzt die Leiterplatte 14 eine Kontaktierung 22. Die Kontaktierung 22 wird von einer prüflingsspezifischen Kontaktanordnung eines nicht dargestellten Prüflings vorgegeben. Die einander zugeordneten Kontakte 18 beziehungsweise 22 sind mit einer elektrisch leitenden Verbindung 24 miteinander verbunden. Die elektrisch leitende Verbindung 24 besteht aus einer auf der Seite 16 aufgebrachten Leiterbahn 26, einer auf der Seite 20 aufgebrachten Leiterbahn 28 sowie eine die Leiterbahnen 26 und 28 miteinander verbindende Durchkontaktierung 30. Die Kontakte 18 beziehungsweise 22 können hier angedeutete Kontaktplättchen 32 besitzen. Mittels der elektrisch leitenden Verbindung 24 erfolgt somit ein Umsetzen der prüffeldspezifischen Kontaktanordnung an der Seite 16 in eine prüflingsspezifische Kontaktanordnung an der Seite 20 der Umsetzeinrichtung 12.

An die Umsetzeinrichtung 12 schließt sich eine auf dieser aufliegende, aus einem Isoliermaterial bestehende Aufnahmeplatte 34 an. Die Aufnahmeplatte 34 besitzt senkrecht zur Umsetzeinrichtung 12 verlaufende Bohrungen 36. Die Anzahl und die Anordnung der Bohrungen 36 entspricht hierbei der Anzahl und der Ausbildung der prüflingsspezifischen Kontaktanordnung der Kontakte 22. Somit ist jedem Kontakt 22 eine Bohrung 36 zugeordnet, die die Aufnahmeplatte 34 durchdringt. Innerhalb der Bohrungen 36 sind hier lediglich angedeutete Federn 38 angeordnet. Die Federn 38 können beispielsweise Schraubendruckfedern sein. An ihrem der Umsetzeinrichtung 12 zugewandten Ende 40 der Federn 38 liegen diese auf den Kontakten 22 auf. Die Federn 38 bestehen aus einem elektrisch leitfähigem Material. Auf der Aufnahmeplatte 34 liegt eine ebenfalls aus einem Isoliermaterial bestehende Führungsplatte 42 auf. Die Führungsplatte 42 besitzt Führungsbohrungen 44, die jeweils zu einer Bohrung 36 der Aufnahmeplatte 34 eine gemeinsame Mittellinie 46 besitzen. Somit fluchtet mit jeder Bohrung 36 der Aufnahmeplatte 34 eine Führungsbohrung 44 der Führungsplatte 42. Die Führungsbohrungen 44 besitzen einen geringeren Durchmesser als die Bohrungen 36. Die Führungsbohrungen 44 werden jeweils von einem Kontaktelement 48 durchgriffen. Zur Führung in den Führungsbohrungen 44 besitzen die Kontaktelemente 48 einen zylinderförmigen Stiftabschnitt 49.

Die Kontaktelemente 48 besitzen an ihrer der Aufnahmeplatte 34 zugewandten Seite einen Halteabschnitt 50, der beispielsweise kugelförmig ausgebildet ist. Ein Durchmesser des Halteabschnittes 50 ist hierbei größer als der Durchmesser der Führungsbohrungen 44. An ihrer dem nicht dargestellten Prüfling zugewandten Seite besitzen die Kontaktelemente 48 jeweils einen Prüfkopf 52. Der Prüfkopf 52 kann beispielsweise von einer Spitze, einer Fläche, einer Halbkugel usw. gebildet sein. Zwischen den Kontaktelementen 48 und den Federn 38 ist ein Zwischenteil 54 angeordnet. Das Zwischenteil 54 besitzt an seiner dem Kontaktelement 48 zugewandten Seite eine Ausnehmung 56, in die das Halteelement 50 des Kontaktelementes 48 eingreift. Im gezeigten Beispiel ist die Ausnehmung 56 beispielsweise als eine halbkugelförmige Vertiefung ausgebildet. An der der Feder 38 zugewandten Seite des Zwischenteils 54 ist ein Bund 58 vorgesehen, an den die Feder 38 angreift. Das Zwischenstück 54 und das Kontaktelement 48 bestehen ebenfalls aus einem elektrisch leitenden Material, so daß eine durchgehende, elektrisch leitende Verbindung von den Kontakten 18 zu den Prüfköpfen 52 der Kontaktelemente 48 gegeben ist.

Insgesamt ist somit eine Anordnung eines Prüfadapters 10 geschaffen, die auf ihrer der Prüfeinrichtung zugewandten Seite eine dem Kontaktpunktfeld der Prüfeinrichtung entsprechende Kontaktanordnung aufweist und an ihrer dem Prüfling zugewandten Seite eine durch das Prüflingsmuster vorgegebene Anordnung der Prüfköpfe 52 besitzt. Der gesamte Aufbau des Prüfadapters 10 ist sehr einfach, was insbesondere dadurch erreicht wird, daß die Federn 38 unmittelbar in den Bohrungen 36 der Aufnahmeplatte 34 geführt sind. Hierdurch ist es möglich, den kleinstmöglichen Abstand zwischen zwei benachbarten Prüfköpfen 52 zu erzielen. Dieser wird jetzt lediglich von der maximal verbleibenden Materialstärke der Aufnahmeplatte 34 zwischen zwei benachbarten Bohrungen 36 bestimmt. Durch den Wegfall irgendwelcher Führungshülsen in den Bohrungen 36 für die Federn 38 kann der Abstand sehr klein gehalten werden. Die Bauhöhe ist ebenfalls sehr klein.

Durch die Führungsplatte 42 wird eine sehr exakte Führung der Kontaktelemente 48 erreicht. Die Führungsbohrungen 44 ergeben die Führungen, so daß die Kontaktelemente sehr präzise mit den Kontakstellen des Prüflings in Kontakt bringbar sind. Der Durchmesser der Führungsbohrungen 44 ist so gewählt, daß dieser nur wenig größer als der Durchmesser der Stiftabschnitte 49 der Kontaktelemente 48 ist, so daß diese im wesentlichen ohne seitliches Spiel gegen die Kraft der Federn 38 axial verschiebbar sind. Die Übertragung der Federkraft der Kontaktelemente 48 erfolgt mittels des Zwischenstücks 54 und dem in der Ausnehmung 56 des Zwischenstücks 54 angeordneten Halteabschnitt 50 der Kontaktelemente 48. Somit wird neben einer exakten Kraftübertragung eine gute elektrische Kontaktierung der Kontaktelemente 48 über die Feder 38 mit den Kontakten 22 gewährleistet. Beim Heranführen eines Prüflings an den Prüfadapter 10 werden die zu prüfenden Kontakte des Prüflings mit den jeweiligen Prüfköpfen 52 der Kontaktelemente 48 in Anlage gebracht. Der Prüfling wird hierbei mit einer Kontaktkraft beaufschlagt, so daß die Kontaktelemente 48 gegen die Kraft der Federn 38 zurückgedrängt werden. Hierdurch wird einerseits die bereits erwähnte gute elektrische Verbindung zwischen den Kontakten 22 und den Prüfköpfen 52 erreicht. Andererseits kann durch die federnde Lagerung der Kontaktelemente 48 ein Höhenausgleich zu den zu prüfenden Kontakten des Prüflings erfolgen.

Die Führungsplatte 42 ist mit der Aufnahmeplatte 34 und der Umsetzeinrichtung 12 durch nicht dargestellte Verbindungselemente sandwichartig verbunden. Es ist vorteilhaft, wenn die Führungsplatte 42 mit der Aufnahmeplatte 34 lösbar, beispielsweise durch eine Schraubverbindung, verbunden ist. Durch die Lösbarkeit der Führungsplatte 42 kann diese abgenommen werden, so daß ein Austausch der Federn 38 und/oder der Kontaktelemente 48 in einfacher Weise möglich ist. Durch die durchmessergrößeren Haltebereiche 50 der Kontaktelemente 48 können diese nicht nach oben, das heißt, zur Prüflingsseite hin, aus dem Prüfadapter 10 entnommen werden beziehungsweise ungewollt herausfallen. Nach Abnahme der Führungsplatte 42 können die Kontaktelemente 48 entnommen und beispielsweise durch andere Kontaktelemente 48 ersetzt werden. Hierdurch wird beispielsweise ein Austausch von Kontaktelementen 48 mit unterschiedlicher Prüfkopfgeometrie möglich. Weiterhin können die Federn 38 in einfacher Weise durch Herausnehmen aus den Bohrungen 36 entnommen beziehungsweise ebenfalls ausgetauscht werden.

Insgesamt ist somit ein Prüfadapter 10 geschaffen, der einfach aufgebaut ist und sich durch eine große Flexibilität auszeichnet. Bei der Herstellung des Prüfadapters 10 kann in einfacher Weise ein für die Herstellung des Prüflings vorhandenes Schema verwendet werden. Liegt beispielsweise ein Kontaktierungs-, ein Löt- oder ein Bohrschema (Computerprogramm) für den Prüfling vor, der die Lage der einzelnen Kontakte des Prüflings bestimmt, kann dieses vorhandene Schema zur Erstellung des Prüfadapters 10 genutzt werden. Entsprechend dem vorhandenen Schema erfolgt das Einbringen der Bohrungen 36 in die Aufnahmeplatte 34, das Einbringen der Führungsbohrungen 44 in die Führungsplatte 42 und das Anlegen der Kontakte 22 auf der Umsetzeinrichtung 12. Durch das gleichzeitige Verwenden eines einmal vorhandenen Schemas wird eine hohe Maßhaltigkeit zwischen den einzelnen Bestandteilen des Prüfadapters 10 erreicht, so daß dieser trotz seiner Einfachheit mit hoher Präzision hergestellt werden kann. Ferner läßt sich der Prüfadapter 10 automatisch bestücken.

Nach einem nicht dargestellten Ausführungsbeispiel kann auf die Anordnung des Zwischenteils 54 verzichtet werden, so daß der Halteabschnitt 50 der Kontaktelemente 48 direkt an die Feder 38 angreift. Hierbei sind den unterschiedlichen konstruktiven Ausgestaltungen sowohl der Feder 38, des Halteelementes 50 und gegebenenfalls des Zwischenelementes 54, außer der von den Bohrungen 36 vorgegebenen Durchmesser, keine Grenzen gesetzt.

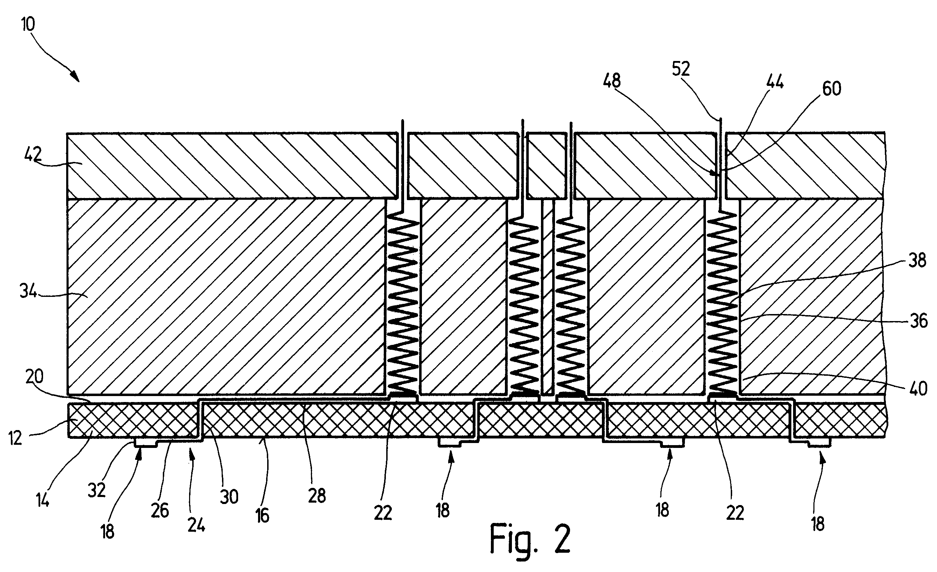

In der Figur 2 ist ein weiterer Prüfadapter 10 dargestellt. Gleiche Teile wie in Figur 1 sind mit gleichen Bezugszeichen versehen und nicht nochmals erläutert. Anstelle der zweiteiligen Ausbildung der Kontaktelemente 48 und der Feder 38 ist hier vorgesehen, daß die Feder 38 einen nicht gewendelten, geradlinigen Abschnitt 60 aufweist, der durch die Führungsbohrungen 44 der Führungsplatte 42 ragt und gleichzeitig den Prüfkopf 52 ausbildet. Die Führungsbohrungen 44 sind hier in ihrer Dimensionierung der Materialstärke des Federelementes 38, insbesondere des Abschnitts 60 des Federelementes 38, angepaßt. Der Abschnitt 60 durchgreift die Führungsbohrungen 44 im wesentlichen ohne seitliches Spiel, so daß die exakte, punktgenaue Kontaktierung möglich ist. Durch die einteilige Ausbildung wird das Kontaktelement 48 gleichzeitig von der Feder 38 mit gebildet. Somit ist ein Element vorhanden, das gleichzeitig die Federwirkung und die Kontaktierung mit dem Prüfling realisiert.

## Patentansprüche

1. Prüfadapter zum elektrischen Kontaktieren eines Prüflings mit einem rasterartig aufgebauten Kontaktpunktfeld einer Prüfeinrichtung, wobei der Prüfadapter eine Umsetzeinrichtung aufweist, die als Leiterplatte ausgebildet ist und auf ihrer dem Kontaktpunktfeld zuordenbaren Seite eine prüffeldspezifische Kontaktanordnung und auf ihrer dem Prüfling zuordenbaren Seite eine prüflingsspezifische Kontaktanordnung aufweist, wobei einander zugeordnete Kontakte der beiden Kontaktanordnungen leitend miteinander verbunden sind, und mit einer Vielzahl federnd nachgiebiger Kontaktelementen, die mit der prüflingsspezifischen Kontaktanordnung leitend in Verbindung stehen und dem Kontaktieren des Prüflings dienen, **dadurch gekennzeichnet**, daß den Kontaktelementen (48) Bohrungen (36) einer Aufnahmeplatte (34) zugeordnet sind, daß in den Bohrungen (36) den Kontaktelementen (48) zugeordnete Federn (38) lagern und daß die Leiterplatte (14) und die Aufnahmeplatte (34) derart einander gegenüberliegen, insbesondere derart aufeinanderliegen, daß die Federn (38) die Kontakte (22) der prüflingsspezifischen Kontaktanordnung kontaktieren.

2. Prüfadapter nach Anspruch 1, **dadurch gekennzeichnet**, daß der Aufnahmeplatte (34) eine Führungsplatte (42) zugeordnet ist, die mit den Bohrungen (36) der Aufnahmeplatte (34) fluchtende Führungsbohrungen (44) für die Kontaktelemente (48) aufweist.

3. Prüfadapter nach einem der vorhergehenden Ansprüche, **dadurch gekennzeichnet**, daß die Kontaktelemente (48) die Führungsbohrungen (44) durchgreifen und jeweils einen innerhalb der Bohrungen (36) der Aufnahmeplatte (34) angeordneten, mit den Federn (36) in Kontakt kommenden Halteabschnitt (50) aufweisen, dessen Durchmesser größer als der Durchmesser der Führungsbohrungen (44) ist.

4. Prüfadapter nach einem der vorhergehenden Ansprüche, **dadurch gekennzeichnet**, daß zwischen den Halteabschnitten (50) und den Federn (38) ein Zwischenteil (54) angeordnet ist.

5. Prüfadapter nach Anspruch 4, **dadurch gekennzeichnet**, daß das Zwischenteil (54) eine dem Halteabschnitt (50) angepaßte Ausnehmung (56) aufweist.

6. Prüfadapter nach einem der vorhergehenden Ansprüche, **dadurch gekennzeichnet**, daß der Halteabschnitt (50) kugelförmig ausgebildet ist.

7. Prüfadapter nach einem der vorhergehenden Ansprüche, **dadurch gekennzeichnet**, daß die Aufnahmeplatte (34) und die Führungsplatte (42) lösbar miteinander verbunden sind.

8. Prüfadapter nach einem der vorhergehenden Ansprüche, **dadurch gekennzeichnet**, daß der Durchmesser der Bohrungen (36) dem Außendurchmesser der Federn (38) entspricht.

9. Prüfadapter nach einem der Ansprüche 1, 2, 7 oder 8, **dadurch gekennzeichnet**, daß die Federn (38) die Führungsbohrungen (44) durchgreifende, nicht gewendelte Abschnitte (60) besitzen, die gleichzeitig die Kontaktelemente (48) bilden.
